Europäisches Patentamt

European Patent Office

Office européen des brevets

(11) Numéro de publication : **0 445 040 A1**

## (12) DEMANDE DE BREVET EUROPEEN

(21) Numéro de dépôt : **91400570.7**

(22) Date de dépôt : **01.03.91**

(51) Int. Cl.⁵ : **H01B 1/12, H01L 29/28**

(30) Priorité : **02.03.90 FR 9002653**

(43) Date de publication de la demande :
**04.09.91 Bulletin 91/36**

(84) Etats contractants désignés :
**DE GB IT**

�["]71 Demandeur : **THOMSON-CSF**
**51, Esplanade du Général de Gaulle**
**F-92800 Puteaux (FR)**

(72) Inventeur : **Broussoux, Dominique**
**Thomson-CSF, SCPI - Cedex 67**
**F-92045 Paris La Defense (FR)**
Inventeur : **Bureau, Jean-Marc**
**Thomson-CSF, SCPI - Cedex 67**
**F-92045 Paris La Défense (FR)**

(74) Mandataire : **Guérin, Michel et al**
**THOMSON-CSF SCPI**
**F-92045 PARIS LA DEFENSE CEDEX 67 (FR)**

㊹ Circuit électrique pour hyperfréquence comprenant une couche de polymère.

㊻ L'invention concerne un circuit électrique comprenant une couche de polymère (2) rendue localement plus conductrice par irradiation pour définir au moins un élément (3) de circuit électrique.
Application notamment à la réalisation de circuits hyperfréquences.

FIG.2

EP 0 445 040 A1

# CIRCUIT ELECTRIQUE POUR HYPERFREQUENCE COMPRENANT UNE COUCHE DE POLYMERE

La présente invention concerne un circuit électrique et en particulier un circuit pour hyperfréquence comprenant des éléments passifs et dont la structure souple ou rigide comporte au moins une couche de polymère. Ce polymère sera avantageusement un polymère thermostable.

L'invention concerne aussi les circuits hyperfréquences intégrés du type MIC (Microwave Integrated Circuit) ou du type MMIC (Monolithic Microwave Integrated Circuit) et hybrides composés de plusieurs circuits intégrés hyperfréquences connectés entre eux.

Plus spécifiquement, l'invention concerne le domaine des éléments passifs de ces circuits tels que les diviseurs de puissance, les coupleurs hybrides à branches ou les quadripoles symétriques réalisés à base de résistances calibrées et les charges hyperfréquences localisées et mises directement en série sur la ligne de propagation.

Selon les méthodes actuellement utilisées par l'homme de l'art, les éléments passifs sont réalisés, soit par dépôts d'encres conductrices sérigraphiées à base d'or ou d'alliage palladium-argent, soit par dépôts métalliques de nickel et de chrome obtenus par métallisation sous vide ou par croissance électrolytique. Ensuite les valeurs des résistances sont ajustées aux valeurs requises par abrasion sous jet de sable., par rayure à pointe de diamant ou par faisceau laser YAG.

D'une façon générale, la réalisation des éléments passifs par ces procédés sont des étapes longues et rigides dans la fabrication des circuits hyperfréquences. En effet, pour chaque dessin de circuit, il est nécessaire de créer un nouvel écran ou un nouveau masque, ce qui à terme est coûteux. De plus, ce type de procédé se limite à la réalisation d'éléments passifs 2 dimensions et ne permet donc pas d'envisager la réalisation d'éléments passifs 3 dimensions pour circuits 3 dimensions.

L'invention a pour but de pallier ces inconvénients. Elle met en oeuvre un matériau polymère qui peut être soit une couche déposée sur un substrat, soit un film autoporteur. L'invention permet d'inscrire en une seule étape les charges hyperfréquences localisées par la création de zones conductrices en surface ou en volume dans la couche de polymère et de les ajuster en valeur de résistance par action sur les paramètres des faisceaux irradiants.

Cette invention a aussi l'avantage de simplifier le procédé général de réalisation de charges hypers puisqu'elle s'adapte à tous les dessins de circuits hyperfréquences 2 dimensions et peut être utilisée dans la conception de circuits hyperfréquences 3 dimensions.

De plus, elle est parfaitement adaptée à la réalisation de charges hyperfréquences dans des circuits dont la structure comporte au moins une couche de polymère.

L'inscription des éléments passifs se fait directement dans la couche de polymère par création de zones à conductivité électrique contrôlée sous l'action d'un faisceau d'ions ou d'un faisceau laser.

L'invention a donc pour objet un circuit électrique, caractérisé en ce qu'il comprend une couche de polymère rendue localement plus conductrice par irradiation pour définir au moins un élément de circuit électrique.

L'invention sera mieux comprise et d'autres avantages apparaîtront à la lecture de la description qui va suivre, donnée à titre non limitatif, et grâce aux dessins annexés parmi lesquels :

– les figures 1 et 2 illustrent un premier exemple de réalisation d'une charge hyperfréquence pour un circuit électrique selon l'invention,

– les figures 3 à 6 illustrent un deuxième exemple de réalisation de charges hyperfréquences pour un circuit électrique selon l'invention,

– les figures 7 à 9 illustrent un troisième exemple de réalisation d'une charge hyperfréquence pour un circuit électrique selon l'invention,

– la figure 10 représente une portion de circuit électrique selon l'invention.

L'invention utilise le procédé connu d'irradiation des polymères par faisceau d'ions ou par faisceau laser qui permet d'obtenir des conductivités induites jusqu'à $10^4 \Omega^{-1}cm^{-1}$, soit 10 fois moins que le graphite et 100 fois moins que le cuivre. Ce procédé est décrit par les articles de S.R. FOREST et al., Applied Physics Letters n° 41, p. 708 (1982), de TATSUMI HIOKI et al., Applied Physics Letters n° 43, p. 30 (1983) et J. DAVENAS et al., Synthetic Metals n° 24, p. 81 (1988). Ces articles enseignent que le maximum de conductivité est atteint en utilisant des polymères thermostables hétérocycliques. Par exemple, les polymères aromatiques peuvent être des polyimides ou des polyphénylquinoxalines, matériaux de plus en plus utilisés en microélectronique du fait de leurs bonnes propriétés diélectriques et électriques ($\varepsilon r < 3,5$ ; $tg\,\delta < 10^{-3}$ et $\rho > 10^{16}\,\Omega$ .cm) et de mise en oeuvre facile. Ces matériaux sont donc d'excellents candidats pour être utilisés dans des circuits hyperfréquences.

Jusqu'à présent ce procédé n'était utilisé que dans des opérations bien spécifiques, notamment pour effectuer des réparations. Ainsi, une soudure partiellement détruite peut être remise en état en déposant sur la zone endommagée une goutte d'un polymère approprié qui, après séchage, est irradié pour le rendre conducteur et restaurer la liaison électrique.

En résumé, avant de décrire quatre exemples plus précis, le procédé d'irradiation par faisceau d'ions permet selon le type d'ions, l'énergie et le temps d'irradiation d'ajuster la profondeur de pénétration et la conductivité électrique induite. Par exemple, pour $10^{16}$ ions/cm² (Xe⁺ à 700 keV), on obtient sur un film de polymère du type de la marque déposée Kapton, une pénétration de 0,5 µm et une résistance variant de 1 à 100 Ω/□ selon le temps d'exposition (6 à 30 secondes).

De même, le procédé d'irradiation par faisceau laser permet en ajustant la longueur d'onde, la puissance du faisceau et la position du point focal, d'obtenir des conductivités induites sur plusieurs microns de profondeurs. Par exemple, un laser de 1 W à 514 nm de longueur d'onde et focalisé sur quelques centaines de µm² permet, après une exposition d'une seconde, d'obtenir une zone conductrice sur 4 µm de profondeur et une résistance variant entre 10 et 200 Ω/□

## EXEMPLE 1

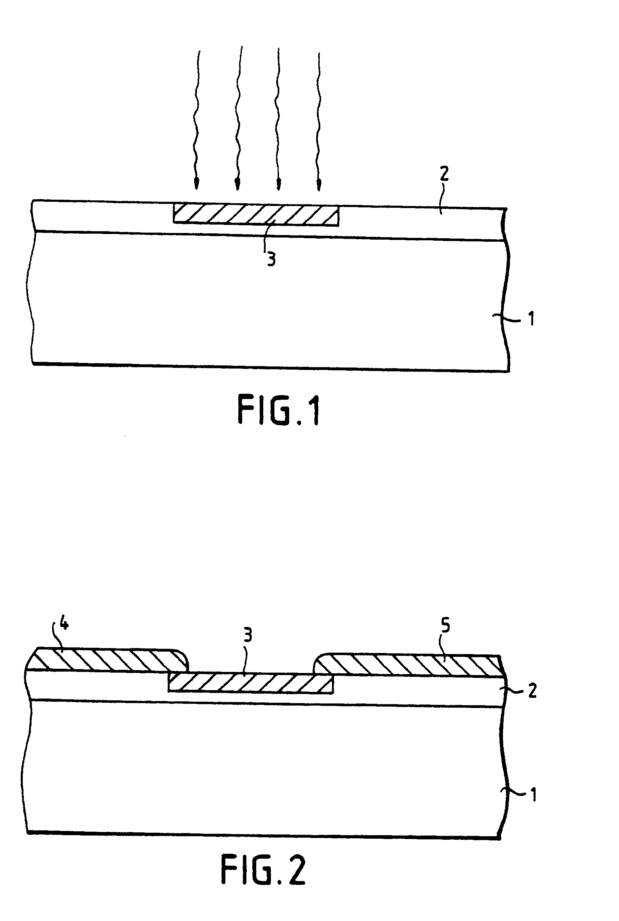

Cet exemple, qui concerne la réalisation d'une charge hyperfréquence, est illustré par les figures 1 et 2.

On utilisera un polymère thermostable (par exemple un polyimide ou un polyphénylquinoxaline), c'est-à-dire un polymère qui résiste à des températures de l'ordre de 300°C, afin de pouvoir réaliser des opérations annexes sur le circuit (report de composants, recuit, etc... )

Sur un substrat diélectrique 1 (en alumine, en silice, en téflon, en arséniure de gallium, en oxyde de titane, etc... ) on dépose une mince couche de polymère 2 d'environ 2 µm d'épaisseur. Le dépôt peut être fait à la tournette ou par pulvérisation. Sur la couche de polymère on déposera ensuite les lignes de propagation des ondes électromagnétiques et on disposera les éléments actifs faisant partie du circuit électrique. La couche de polymère est d'épaisseur suffisamment faible et de constante diélectrique suffisamment faible pour ne pas perturber la propagation des ondes en gardant l'impédance de la ligne à celle qu'elle aurait si elle était disposée directement sur le substrat.

Ensuite une ou plusieurs zones conductrices telles que 3, sont créées par irradiation avec un faisceau d'ions ou un faisceau laser. Ce faisceau d'ions ou ce faisceau laser peuvent être pilotés en coordonnées spatiales, en puissance et en vitesse de balayage par un logiciel approprié.

Par exemple, la réalisation d'une charge hyperfréquence de 50 Ω/□ nécessite 20 secondes d'irradiation avec des ions Xe⁺, mais ce temps peut être réduit à 1 seconde d'irradiation si l'on chauffe la couche autour de sa température de transition vitreuse (250 à 400°C selon le matériau). De même, avec un faisceau laser dans le visible à 514 nm et une densité de puissance supérieure à $10^4$ W/cm², on réalise une charge hyperfréquence de 50 Ω/□ en moins d'une seconde.

La charge hyperfréquence 3 ainsi créée pourra être connectée au reste du circuit électrique par des électrodes 4 et 5, par exemple en aluminium ou en or, déposées par toute méthode de l'art connu.

Les dimensions des charges ainsi réalisées peuvent être typiquement comprises entre 50 µm x 50 µm et 200 µm x 200 µm.

## EXEMPLE 2

Cet exemple, qui concerne la réalisation de charges hyperfréquences de façon collective, est illustré par les figures 3 à 6.

Dans certains circuits, toutes les charges hyperfréquences utiles peuvent être de valeur égale. Il est donc intéressant de réaliser leur dépôt de façon collective. Dans ce cas, le procédé de fabrication de ces charges comporte des étapes supplémentaires de dépôt d'une résine de masquage, de l'insolation de cette résine au travers d'un masque et de son développement après l'irradiation.

La figure 3 représente un substrat diélectrique 11 sur lequel on a déposé une mince couche de polymère thermostable 12. Une couche 16 de résine positive a été déposée sur la couche de polymère 12. La résine est insolée localement sous l'effet de rayons ultraviolets au travers du masque 17. Une fois l'insolation effectuée, le masque est retirée et la résine insolée est éliminée selon les méthodes de l'art connu, ce qui rend apparent la couche de polymère 12.

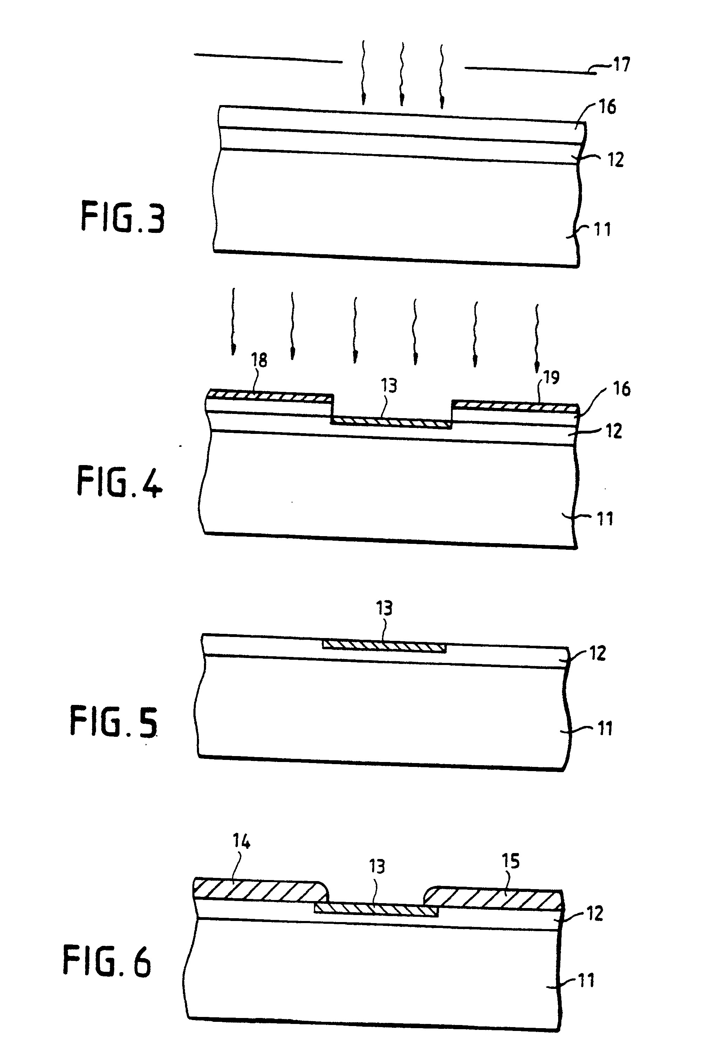

La figure 4 illustre l'étape d'irradiation de la couche de polymère, par exemple par un faisceau d'ions pour créer une zone plus conductrice 13. A cette occasion, des zones à conductivité induite 18 et 19 sont créées à la surface de la couche de résine restante. Cette couche de résine restante est éliminée par la technique connue sous l'appellation de "lift-off".

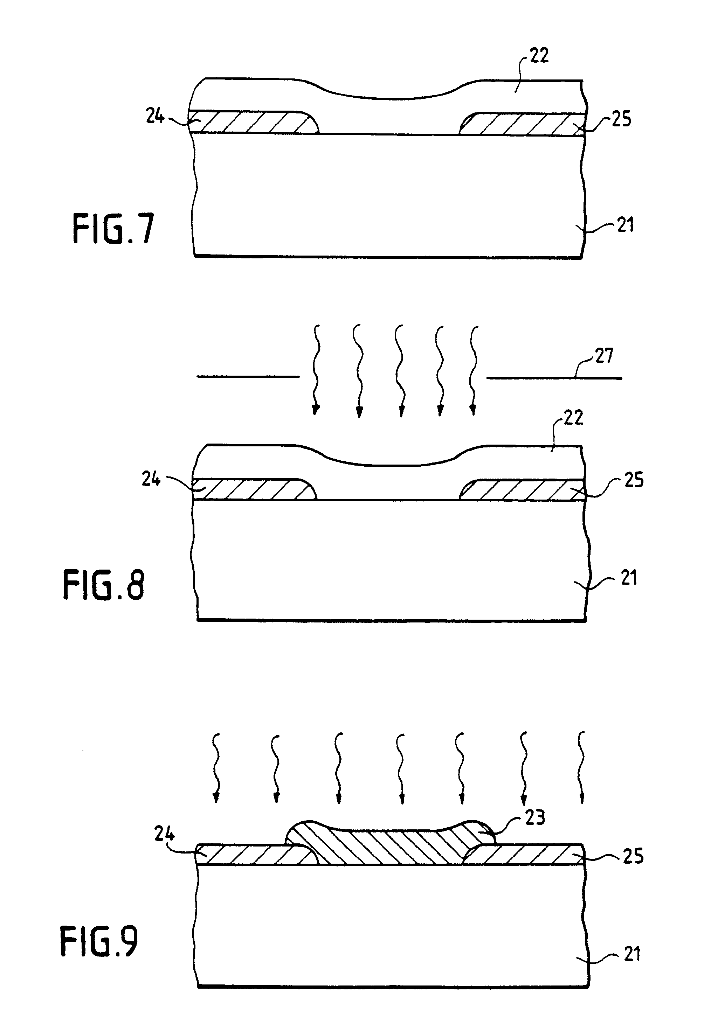

La figure 5 représente le résultat obtenu : une couche de polymère thermostable 12 sur un substrat 11 et comprenant une zone plus conductrice 13.

Des électrodes 14 et 15 de liaison de la charge hyperfréquence 13 au reste du circuit électrique sont ensuite déposées comme le montre la figure 6.

Sur les figures 3 à 6 on a représenté la formation d'une seule charge par souci de simplification mais, comme il a été dit plus haut, la mise en oeuvre de ce procédé est avantageuse pour la réalisation collective de charges.

## EXEMPLE 3

Cet exemple, qui concerne la réalisation de charges hyperfréquences, est illustré par les figures 7 à 9.

Il concerne la réalisation de charges hyperfréquences avec un polyimide photosensible aux ultraviolets. Dans ce cas, l'utilisation d'une résine photosensible de masquage n'est pas nécessaire.

Le procédé de réalisation mis en oeuvre comprend trois étapes.

Au cours de la première étape, illustrée par la figure 7, on dépose une couche de polyimide photosensible 22 sur un substrat diélectrique 21 déjà équipé des électrodes 24 et 25 de liaison de la charge hyperfréquence.

Au cours de la deuxième étape, illustrée par la figure 8, on insole la couche de polyimide 22 par un rayonnement ultraviolet au travers d'un masque 27, puis on effectue le développement qui permet de ne garder que la partie insolée de la couche de polyimide.

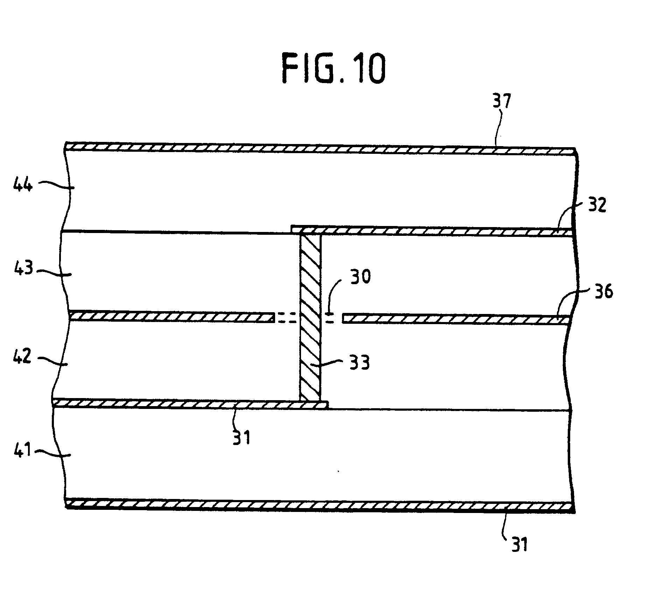

Au cours de la troisième étape, illustrée par la figure 9, on irradie par faisceau d'ions ou par faisceau laser pour obtenir une charge hyperfréquence 23.

Comme pour l'exemple 1, on peut chauffer le substrat pour réduire le temps d'irradiation.

A noter que pour cet exemple comme pour les deux exemples précédents, on peut se passer du substrat rigide et utiliser directement un film autoporteur de polyimide ou de polymère thermostable souple permettant alors de réaliser un circuit hyperfréquence souple contenant les lignes de propagation et les charges hyperfréquences réalisées par les méthodes décrites précédemment.

## EXEMPLE 4

Dans cet exemple, on décrit la possibilité d'étendre la réalisation de charges hyperfréquences hors du plan.

Pour des raisons de découplage, les lignes de propagation d'un plan à un autre doivent être séparées par un plan de masse qu'il faut traverser pour réaliser la charge hyperfréquence. Dans ce cas, pour connecter deux lignes de propagation sur deux plans signaux différents, il peut être intéressant de réaliser la connexion par une charge hyperfréquence calibrée.

La figure 10 représente une portion de circuit hyperfréquence comprenant une charge hyperfréquence hors du plan. Ce circuit est formé de quatre couches diélectriques superposées 41, 42, 43 et 44 en polymère thermostable. La couche 41 est comprise entre l'électrode de masse 35 et l'électrode signal 31, la couche 42 entre l'électrode signal 31 et l'électrode de masse 36, la couche 43 entre l'électrode de masse 36 et l'électrode signal 32 et la couche 44 entre l'électrode signal 32 et l'électrode de masse 37. Une absence de métallisation forme un trou 30 dans l'électrode de masse 36. Ce trou 30 est rempli du polymère thermostable. Il y a donc continuité dans la masse de polymère entre les couches 42 et 43.

La fabrication du circuit de la figure 10 ne pose pas de problème pour l'homme de l'art. Les couches diélectriques peuvent être déposées à la tournette, l'une après l'autre en alternance avec le dépôt des électrodes.

La charge 33 est réalisée pendant la fabrication du circuit alors que celui-ci ne comprend encore que les couches diélectriques 41, 42 et 43 et les électrodes 35, 31 et 30, c'est-à-dire juste avant le dépôt de l'électrode signal 32.

La charge 33 est obtenue grâce à un faisceau laser d'énergie suffisante, la partie correspondante du polymère thermostable étant en élément plus conducteur. Le point focal du faisceau est déplacé du bas vers le haut dans le cas où la source se trouve placée au-dessus du circuit, c'est-à-dire de l'électrode 31 jusqu'au sommet de la couche 43. On dépose ensuite l'électrode signal 32, puis la couche diélectrique d'isolation 44 et enfin l'électrode supérieure de masse 37.

## Revendications

1 - Procédé de fabrication d'un circuit électrique, caractérisé en ce qu'il comprend le dépôt d'une couche de polymère (2) et l'irradiation par un faisceau d'ions de cette couche pour la rendre plus conductrice et définir au moins un élément ( 3 ) de circuit électrique.

2 - Procédé de fabrication d'un circuit électrique selon la revendication 1, caractérisé en ce que la couche de polymère rendue plus conductrice constitue une charge hyperfréquence.

3 - Procédé de fabrication d'un circuit électrique selon l'une des revendications 1 ou 2, caractérisé en ce que l'irradiation est effectuée localement dans une partie de la couche de polymère.

4 - Procédé de fabrication d'un circuit électrique selon l'une des revendications 1 ou 2, caractérisé en ce que la couche de polymère est photogravée préalablement à l'irradiation.

5 - Procédé de fabrication d'un circuit électrique selon l'une des revendications 1 à 4, caractérisé en ce que la couche de polymère (2) est déposée sur un substrat (1).

6 - Procédé de fabrication d'un circuit électrique selon l'une des revendications 1 à 4, caractérisé en ce que la couche de polymère constitue un film autoporteur.

7 - Procédé de fabrication d'un circuit électrique selon l'une des revendications 1 à 5, caractérisé en ce que le polymère est un polymère thermostable.

8 - Procédé de fabrication d'un circuit électrique selon la revendication 7, caractérisé en ce que le polymère est un polyimide ou un polyphénylquinoxaline.

FIG.1

FIG.2

FIG.3

FIG.4

FIG.5

FIG.6

FIG.7

FIG.8

FIG.9

# FIG. 10

**Office européen**

**des brevets**

# RAPPORT DE RECHERCHE EUROPEENNE

Numéro de la demande

EP    91 40 0570

Page 1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| X | EP-A-254609 (UNIVERSITE DE LIMOGES) <br> * colonne 1, ligne 49 - colonne 2, ligne 46 * | 1, 6 | H01B1/12 <br> H01L29/28 |
| Y | | 2, 3, 5, 7, 8 | |
| Y | JOURNAL OF MATERIALS SCIENCE LETTERS. <br> vol. 7, no. 9, septembre 1988, LONDON GB <br> pages 922 - 923; A. BIDARIAN et al.: <br> "Microwave conductivity of doped <br> poly-p-phenylene-benzobis-thiazole" <br> * le document en entier * | 2 | |
| A | | 1, 6 | |
| Y | JOURNAL OF APPLIED PHYSICS <br> vol. 55, no. 4, 15 février 1984, <br> pages 1212 - 1214; T. VENKATESAN et al.: <br> "Ion beam irradiated via-connect through an <br> insulating polymer layer" <br> * pages 1212 - 1213, colonne de gauche; figure 1 * | 3, 5 | |
| A | | 1, 7 | DOMAINES TECHNIQUES RECHERCHES (Int. Cl.5 ) |
| Y | NUCLEAR INSTRUMENTS & METHODS IN PHYSICS <br> RESEARCH, SECTION B <br> vol. B34, no. 3, septembre 1988, AMSTERDAM <br> pages 337 - 346; I.H. LOH et al.: <br> "Conducting polymers by ion implantation" <br> * pages 337 - 338 * | 7, 8 | H01L <br> H01B <br> C08J <br> H01P <br> H01C |
| A | | 1, 3, 5 | |
| A | JOURNAL OF APPLIED PHYSICS. <br> vol. 59, no. 4, 15 février 1986, NEW YORK US <br> pages 1111 - 1116; John BARTKO et al.: <br> "Highly conductive poly(phenylene sulfide) <br> prepared by high-energy ion irradiation" <br> * page 1111 * <br> * abstract, table II * | 1, 5, 7 | |

-/--

Le présent rapport a été établi pour toutes les revendications

| Lieu de la recherche | Date d'achèvement de la recherche | Examinateur |
|---|---|---|
| BERLIN | 22 AVRIL 1991 | KLOPFENSTEIN P. |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

                                                       
& : membre de la même famille, document correspondant

EPO FORM 1503 03.82 (P0402)

Office européen
des brevets

**RAPPORT DE RECHERCHE EUROPEENNE**

Numero de la demande

EP    91 40 0570
Page 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | IEEE CIRCUITS AND DEVICES MAGAZINE. vol. 5, no. 3, mai 1989, NEW YORK US pages 33 - 37; S.R. FORREST: "Organic-on-inorganic semiconductor heterojunctions: Building block for the next generation of optoelectronic devices?" * pages 36 - 37; figures 6-8 * --- | 1-3, 5 | |
| A | MICROELECTRONICS JOURNAL. vol. 18, no, 3, mai 1987, LUTON GB pages 22 - 40; A.K. COUSENS et al.: "Polymer thick film systems and surface mount techniques" * page 39, alinéa 12 * --- | 1, 3, 5 | |
| A | US-A-4491605 (HARRY MAZUREK ET AL.) * colonne 2, ligne 65 - colonne 3, ligne 38 * --- | 1, 5 | |
| A | PATENT ABSTRACTS OF JAPAN vol. 6, no. 162 (P-137)(1040) 25 août 1982, & JP-A-57 081234 (MATSUSHITA DENKI SANGYO K.K.) 21 mai 1982. * le document en entier * ----- | 4, 5, 7, 8 | **DOMAINES TECHNIQUES RECHERCHES (Int. Cl.5)** |

Le présent rapport a été établi pour toutes les revendications

| Lieu de la recherche | Date d'achèvement de la recherche | Examinateur |
|---|---|---|
| BERLIN | 22 AVRIL 1991 | KLOPFENSTEIN P. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................
& : membre de la même famille, document correspondant

EPO FORM 1503 03.82 (P0402)